# EUROPÄISCHE PATENTANMELDUNG

(11) **EP 4 181 405 A1**
(43) Veröffentlichungstag der Anmeldung: **17.05.2023**
(21) Anmeldenummer: 22205171.6
(22) Anmeldetag: 02.11.2022
(51) Int. Cl.: H04B 1/04, H04B 1/18, H03H 7/40, G01D 4/00

(54) **VERFAHREN ZUR ANTENNENABSTIMMUNG**

(30) Priorität: 16.11.2021 DE 102021129836
(71) Anmelder: Diehl Metering Systems GmbH, 90451 Nürnberg (DE)
(72) Erfinder: Schröter, Simon, 91052 Erlangen (DE); Becke, Gerhard, 91301 Forchheim (DE); Schmidt, Christoph, 90403 Nürnberg (DE); Zocher, Nicole, 91639 Wolframs-Eschenbach (DE)
(74) Vertreter: Diehl Patentabteilung

(57) **Zusammenfassung**

Verfahren zum Verbessern der Antennenanpassung bei einem Funkknoten, vorzugsweise eines Sensor- und/oder Aktor-Funkknotens, dadurch gekennzeichnet, dass ein Funksignal oder zumindest ein Teil desselben aus der Antenne und/oder aus dem Sendepfad des Funkknotens ausgekoppelt werden bzw. wird daraus im Funkknoten die Impedanz und/oder die Resonanzfrequenz der Antenne ermittelt wird, und in Abhängigkeit der ermittelten Impedanz und/oder Resonanzfrequenz mittels einer auf die Antenne einwirkenden Schaltung die Impedanz und/oder die Resonanzfrequenz der Antenne angepasst wird.

## Beschreibung

Die vorliegende Erfindung betrifft zum einen ein Verfahren zur Verbesserung der Antennenanpassung bei einem Funkknoten gemäß dem Oberbegriff des Anspruchs 1 zum anderen einen Funkknoten gemäß dem Oberbegriff des Anspruchs 15.

### Technologischer Hintergrund

Funkknoten kommen in verschiedenen Bereichen zum Einsatz. Bei Funkknoten kann es sich um Sensorknoten, Aktorknoten oder daraus kombinierten Knoten handeln. Beispielsweise kommen derartige Funkknoten bei Verbrauchsmesszählern zur Übertragung von Messdaten zum Einsatz. Bei Verbrauchsmesszählern kann es sich beispielsweise um Durchflusszähler oder Stromzähler handeln. Die Funknoten sind hierbei möglichst klein gebaut.

Die erzielbare Funkreichweite des Funkknotens hängt von der Antennenverstimmung ab. Je größer die Antennenverstimmung ist, desto kleiner ist die abgestrahlte Sendeleistung des Funkknotens im Sendefall und desto geringer ist die erzielbare Reichweite des Funksignals. Im Empfangsfall wird durch die Antennenverstimmung die Empfangsempfindlichkeit des Funkknotens reduziert, was ebenfalls zu geringerer Reichweite einer Funkverbindung führt. Die Antennenverstimmung hängt von Umgebungseinflüssen, z. B. der Einbausituation, Metallteilen oder Dielektrika in der Nähe des Funkknotens, sowie von fertigungsbedingten Toleranzen der Komponenten ab. Daher ist eine gute Antennenabstimmung des Funkmoduls erwünscht, um eine ausreichende Qualität des Funksignals zu erreichen.

Ein Netzanschluss zur Energieversorgung ist typischerweise nicht verfügbar, sodass die Funkknoten energieautark mittels Batterien mit elektrischer Energie versorgt werden. Bei diesen Batterien handelt es sich vorzugsweise um sogenannte Longlife-Batterien. Die Batterien decken die komplette Lebensdauer des Zählers ab, welche typischerweise im Bereich von 12 bis 16 Jahren liegt. Der Energiebedarf des Funkknoten bei der Funkkommunikation hängt ebenfalls von der Antennenverstimmung ab. Abhängig vom im Funkknoten verwendeten Leistungsverstärkers kann durch eine Verstimmung der Antenne der Energiebedarf des Funkknotens größer sein als im nominellen Betriebsfall ohne Antennenverstimmung.

Daher ist es wichtig, Maßnahmen zu ergreifen, welche die abgestrahlte Sendeleistung, die Empfangsempfindlichkeit und den Energiebedarf des Funkknotens auch bei Vorliegen einer Antennenverstimmung erhalten.

### Druckschriftlicher Stand der Technik

Die EP 3 285 403 A1 offenbart ein Verfahren zum Verbessern der Antennenanpassung bei einem Smartmeter-Zähler. Indem Smartmeter-Zähler sind verschiedene Antennenabstimmungen hinterlegt, mit welchen der Smartmeter-Zähler Datenpakete aussendet. Hierbei werden von einem Zähler nacheinander herkunftscodierte Pakete bei definierter Sendefrequenz mit unterschiedlichen Einstellungen bezüglich der Abstimmung zur Antennenanpassung im Uplink an einen Konzentrator ausgesendet. In einem Konzentrator werden diese Pakete empfangen und hinsichtlich ihrer Empfangsfeldstärke ausgewertet. Die Einstellungen, welche zu einem brauchbaren Empfang geführt haben, werden im Downlink zurück an den Zähler übertragen, woraufhin dieser fortan an mit diesen Einstellungen zur Antennenanpassungen sendet. Einerseits sind nur begrenzte Antennenanpassungen anwählbar, andererseits wird im Rahmen der Anpassung der Funkkanal belastet. Des Weiteren erfordert das Verfahren ein bidirektionales Funksystem zwischen dem Smartmeter-Zähler und dem Konzentrator. Demnach kann das Verfahren nicht autark von dem Smartmeter-Zähler durchgeführt werden. Im Übrigen erfordert dieses Verfahren einen erhöhten Energieaufwand.

### Aufgabe der vorliegenden Erfindung

Aufgabe der vorliegenden Erfindung ist es ein verbessertes Antennenadaptionsverfahren zur Verfügung zu stellen.

### Lösung der Aufgabe

Die vorstehende Aufgabe wird durch ein Verfahren mit den Merkmalen des Anspruchs 1 sowie durch einen Funkknoten mit den Merkmalen gemäß Anspruch 15 gelöst. Zweckmäßige Ausgestaltungen des erfindungsgemäßen Verfahrens und des erfindungsgemäßen Funkknotens werden in den zugehörigen abhängigen Ansprüchen beansprucht.

Erfindungsgemäß wird ein Funksignal, z. B. ein Hochfrequenz (HF)-Signal, oder zumindest ein Teil desselben aus der Antenne und/oder aus dem Sendepfad des Funkknotens ausgekoppelt, daraus im Funkknoten die Impedanz und/oder die Resonanzfrequenz der Antenne bzw. die Antennenverstimmung ermittelt bzw. geschätzt und in Abhängigkeit der ermittelten Impedanz und/oder Resonanzfrequenz mittels einer auf die Antenne einwirkenden Schaltung die Impedanz und/oder die Resonanzfrequenz der Antenne angepasst. Durch die auf die Antenne einwirkende Schaltung kann demnach die Impedanz und/oder die Resonanzfrequenz der Antenne im Funkknoten ohne die Notwendigkeit einer Uplink- bzw. Downlink-Verbindung angepasst werden. Das komplette Verfahren kann somit von dem Funkknoten selbsttätig, d. h. autark, durchgeführt werden. Das Verfahren ist somit unabhängig von einem Empfänger bzw. übergeordneten Datensammler und kann durchgeführt werden, selbst wenn sich der Funkknoten in keinem Netzwerk befindet. Durch das Anpassen der Impedanz und/oder Resonanzfrequenz der Antenne können Umgebungseinflüsse und/oder fertigungsbedingte Toleranzen des Funcknotens und/oder Alterungseffekte, welche eine Antennenverstimmung bewirken, ausgeglichen werden.

Zweckmäßigerweise umfasst die auf die Antenne einwirkende Schaltung ein, vorzugsweise schaltbares, Netzwerk, welches mindestens eine, vorzugsweise mehrere, Kapazitäten und/oder mindestens eine, vorzugsweise mehrere, Induktivitäten umfasst. Die mindestens eine Kapazität und/oder die mindestens eine Induktivität wirkt bzw. wirken sich auf die Impedanz und/oder Resonanzfrequenz der Antenne aus. Sofern diese in einem schaltbaren Netzwerk zusammengeschalten sind, kann durch eine Beschalten des Netzwerks die Impedanz und/oder Resonanzfrequenz der Antenne verändert werden. Zweckmäßigerweise können die einzelnen Kapazitäten und/oder Induktivitäten einzeln ansteuerbar sein. Insbesondere können die Kapazitäten und/oder Induktivitäten unterschiedlichen Werte aufweisen.

Zweckmäßigerweise kann die auf die Antenne einwirkende Schaltung mindestens eine Varaktordiode umfassen. Die Varaktordiode umfasst eine einstellbare Kapazität, welche von einer an der Varaktordiode anliegenden Steuerspannung, insbesondere Gleichstrom (DC)-Steuerspannung, abhängt. Je größer die Steuerspannung ist, desto kleiner ist die Kapazität der Varaktordiode und umgekehrt.

Vorteilhafterweise kann die auf die Antenne einwirkende Schaltung galvanisch oder kapazitiv oder induktiv, d. h. feldgebunden, an die Antenne gekoppelt sein. Hierfür kann die Antenne kann derart ausgestaltet sein, dass sie Koppelstrukturen, z. B. Koppelbereiche zur kapazitiven Kopplung oder Koppelschleifen zur induktiven Kopplung, aufweist. Hierdurch wird die kapazitive oder induktive Kopplung der einstellbaren Impedanz auf die Antenne erleichtert.

Vorzugsweise kann die galvanische oder kapazitive oder induktive Kopplung der auf die Antenne einwirkende Schaltung an der Antenne, z. B. an einem beliebigen Bereich der Antenne, und/oder am Antennenfußpunkt vorgesehen sein. Hierzu kann die Antenne zweckmäßigerweise derart ausgestaltet sein, dass sie neben dem Fußpunkt an weiteren Bereichen z. B. galvanisch mit der auf die Antenne einwirkenden Schaltungen verbunden sein kann. Hierbei können der Sendepfad und die auf die Antenne einwirkende Schaltung einen gemeinsamen Koppelpunkt mit der Antenne aufweisen.

Dadurch, dass es sich bei der mindestens einen Kapazität um einen Koppelkondensator und/oder bei der mindestens einen Induktivität um eine Drossel handelt, können der Steuerkreis auf die Antenne einwirkenden Schaltung und die Antenne zur Vermeidung von Störungen voneinander entkoppelt werden. Infolgedessen kann vermieden werden, dass das Funksignal der Antenne die Funktion des Mikrocontrollers stört.

Zweckmäßigerweise umfasst die auf die Antenne einwirkende Schaltung einen Mikrocontroller und/oder einen Regler. Der Mikrocontroller und/oder der Regler können die Ansteuerung der auf die Antenne einwirkenden Schaltung verändern und hierdurch Einfluss auf die Impedanz und/oder Resonanzfrequenz der Antenne nehmen. Der Mikrocontroller und/oder der Regler können somit die Impedanz und/oder Resonanzfrequenz der Antenne verändern bzw. anpassen. Bei dem Mikrocontroller handelt es sich insbesondere um eine digitale Steuerung. Der Regler kann digital oder analog ausgeführt werden.

Vorteilhafterweise wird zur Auskopplung des Funksignals oder zumindest eines Teils desselben aus der Antenne und/oder dem Sendepfad
- eine von der Antenne reflektierte Welle ausgekoppelt, oder
- die von der Antenne abgestrahlte Leistung bzw. HF-Leistung oder zumindest ein Teil derselben abgegriffen, oder
- die auf der Antenne befindliche Energie bzw. HF-Energie oder zumindest ein Teil derselben abgegriffen, oder
- ein Teil eines Funksignals abgegriffen, der sich aus der Überlagerung einer vorlaufenden und einer von der Antenne rücklaufenden oder reflektierten Welle ergibt.

Die von der Antenne rücklaufende Welle gemäß der ersten Alternative entspricht hierbei dem Anteil des Funksignals, welcher nicht ausgesendet wurde und nicht in der Antenne in Verlustwärme umgesetzt wurde. Je größer die rücklaufende Welle ist, desto schlechter ist die Antennenabstimmung. Die rücklaufende Welle wird hierbei vorzugsweise von einem Koppler, insbesondere einem Hybridkoppler oder einem Richtkoppler, aus dem Sendepfad ausgekoppelt.

Die von der Antenne abgestrahlte HF-Leistung bzw. HF-Energie gemäß der zweiten bzw. dritten Alternative hingegen ist in ihrer Höhe von der Leistung bzw. Energie des Funksignals auf der Antenne abhängig. Die HF-Leistung bzw. HF-Energie wird über eine, vorzugsweise feldgebundene, Koppelantenne und/oder ein Sensorelement und/oder ein Auskoppelelement, z. B. einen Auskoppelwiderstand, abgegriffen.

Der Abgriff des Teils des Funksignals gemäß der vierten Alternative erfolgt zweckmäßigerweise über einen, z. B. im Sendepfad angeordneten, Auskoppelwiderstand. Der damit abgegriffene Teil des Funksignals bzw. dessen HF-Spannung ist eine Überlagerung der Spannungen der vorlaufenden Welle und der rücklaufenden Welle.

Hierdurch werden verschiedene Möglichkeiten zum Abgriff des Funksignals oder zumindest eines Teils desselben ermöglicht. Die rücklaufende Welle oder die abgegriffene Leistung oder die abgegriffene Energie oder der abgegriffene Teil des Funksignals werden hierbei von der Impedanz und/oder der Resonanzfrequenz der Antenne beeinflusst. Diese können somit zur Bestimmung der Antennenverstimmung ausgewertet werden.

Dadurch, dass die rücklaufende Welle oder die abgegriffene Leistung oder die abgegriffene Energie oder der abgegriffene Teil des Funksignals einer Gleichrichterschaltung, z. B. einer Gleichrichterschaltung aus Dioden, zugeführt werden kann, kann von der Gleichrichterschaltung eine DC-Spannung ausgegeben werden, welche abhängig von der rücklaufenden Welle oder der abgegriffene Leistung oder der abgegriffene Energie oder dem abgegriffene Teil des Funksignals ist. Die von der Gleichrichterschaltung ausgegebene DC-Spannung gibt infolgedessen Auskunft über die Impedanz und/oder die Resonanzfrequenz der Antenne bzw. die Antennenverstimmung. Hierdurch kann vorzugsweise ein Minimum oder ein Maximum der von der Gleichrichterschaltung ausgegebenen DC-Spannung mit einer gewünschten bzw. optimalen Antennenanpassung korrespondieren. Alternativ kann eine gewünschte bzw. optimale Antennenanpassung vorliegen, wenn die DC-Spannung mit einem Referenzspannungswert korrespondiert. Die DC-Spannung wird vorzugsweise dem Mikrocontroller für eine Auswertung und/oder Steuerung der auf die Antenne einwirkenden Schaltung zugeleitet.

Indem die rücklaufende Welle oder die abgegriffene Leistung oder die abgegriffene Energie oder der abgegriffene Teil des Funksignals durch Abtastung oder mittels eines Analog-Digital-Wandlers, d. h. das jeweilige HF-Signal, direkt digitalisiert wird, kann auf eine Gleichrichterschaltung verzichtet werden. Zudem liegt hierdurch eine digitalisierte Information zu der Impedanz und/oder zu der Resonanzfrequenz der Antenne bzw. zu der Antennenverstimmung vor, welche wie die DC-Spannung der Gleichrichterschaltung ausgewertet werden kann. Diese digitalisierte Information kann einem Auswertealgorithmus zur Verfügung gestellt werden.

Indem ein Phasenvergleich zwischen dem aus der Antenne ausgekoppelten Funksignal bzw. der aus der Antenne abgegriffenen HF-Leistung oder HF-Energie und dem aus dem Sendepfad ausgekoppelten Funksignal vorgenommen werden kann, kann aus der Phasendifferenz die Richtung der Antennenverstimmung bestimmt werden. Somit kann die auf die Antenne einwirkende Schaltung direkt in eine bestimmte Richtung beeinflusst werden, sodass nicht der gesamte Abstimmbereich der Antenne durchsweept werden muss. Der Phasenvergleich kann insbesondere mittels eines Phasenkomparators, z. B. eines aus Dioden aufgebauten Mischers, durchgeführt werden, welcher eine Gleichspannung ausgeben kann, welche abhängig von der Phasendifferenz ist. Zweckmäßigerweise wird das Funksignal mittels eines Leistungsteilers aus dem Sendepfad ausgekoppelt.

Vorzugsweise kann die Antennenanpassung mittels eines binären Suchverfahrens oder mittels eines, insbesondere iterativen, Algorithmus oder mittels eines SWEEP-Verfahrens oder in einem geschlossenen Regelkreis vorgenommen werden. Das SWEEP-Verfahren wird z. B. von dem Mikrocontroller durchgeführt. Hierbei sweept bzw. fährt oder taktet der Mikrocontroller die einzelnen Antennenanpassungen aufgrund der einstellbaren Impedanz bzw. unterschiedlicher Steuerspannungswerte der Varaktordiode durch, sodass die Impedanzen und/oder Resonanzfrequenzen im, vorzugsweise kompletten, Abstimmbereich der Antenne abgedeckt ist. Hierdurch kann eine günstige Impedanz und/oder die Resonanzfrequenz der Antenne bzw. die Antennenverstimmung bestimmt werden.

Bei der Alternative des geschlossenen Regelkreises wird die vorliegende Impedanz und/oder Resonanzfrequenz bzw. eine damit korrespondierende Spannung mit einem Referenzwert verglichen. Der geschlossene Regelkreis passt die einstellbare Impedanz dahingehend an, dass eine gewünschte bzw. günstige Impedanz und/oder die Resonanzfrequenz der Antenne erreicht wird. Zweckmäßigerweise können aus der Differenz zwischen der vorliegenden Impedanz und/oder Resonanzfrequenz bzw. der damit korrespondierenden Spannung, insbesondere und dem Referenzwert weitere Informationen, z. B. eine Richtung der Antennenverstimmung, abgeleitet werden. Hierdurch kann vorteilhafterweise die Antennenverstimmung bzw. Antennenabstimmung unmittelbar während des Aussendens des Funksignals angepasst werden.

Zweckmäßigerweise umfasst das Verfahren eine Suchphase, in der die Impedanz und/oder die Resonanzfrequenz der Antenne und/oder die Einbau- und/oder Umgebungssituation und/oder die fertigungsbedingten Toleranzen der Komponenten des Funkknotens ermittelt bzw. erfasst, und insbesondere abgespeichert, werden können bzw. kann, und eine Betriebsphase, während der die in der Suchphase ermittelte Impedanz und/oder die Resonanzfrequenz der Antenne und/oder Einbau- und/oder Umgebungssituation und/oder ermittelten fertigungsbedingten Toleranzen der Komponenten des Funkknotens mit der aktuellen bzw. momentanen Impedanz und/oder Resonanzfrequenz der Antenne und/oder Einbau- und/oder Umgebungssituation, z. B. bei jeder Aussendung, verglichen werden bzw. wird und (a) bei einer Abweichung aus dem Vergleich und/oder (b) periodisch, in gleichen oder ungleichen Zeitabständen, eine neue Suchphase gestartet wird. Hierdurch kann die Impedanz und/oder Resonanzfrequenz der Antenne direkt überwacht werden und bei einer Abweichung die Suchphase direkt gestartet werden. Alternativ oder zusätzlich kann die Suchphase periodisch, in gleichen oder ungleichen Zeitabständen, selbsttätig gestartet werden. Hierdurch wird ein Aussenden eines Funksignals bei einer Antennenverstimmung vermieden. Hierdurch wird ein energiesparender Betrieb des Funkknotens ermöglicht. Vorteilhafterweise kann die während der Suchphase im Sendebetrieb ermittelte Impedanz und/oder Resonanzfrequenz der Antenne im Funkknoten abgespeichert und im Empfangsbetrieb verwendet werden. Dadurch kann auch der Empfangsbetrieb mit optimaler Antennenanpassung realisiert werden.

Indem die Anpassung der Impedanz und/oder der Resonanzfrequenz der Antenne in diskreten Stufen erfolgen kann, kann die Impedanz und/oder die Resonanzfrequenz der Antenne passend an die Gegebenheiten angepasst werden.

Die vorliegende Erfindung betrifft auch einen Funkknoten gemäß dem Oberbegriff des Anspruchs 15. Erfindungsgemäß wird der Funkknoten nach einem Verfahren gemäß der Ansprüche 1 - 14 betrieben.

Zweckmäßigerweise sind bzw. ist als Mittel zur Auskopplung ein Koppler und/oder eine Koppelantenne und/oder ein Sensorelement und/oder ein Auskoppelelement und/oder ein Auskoppelwiderstand vorgesehen.

Vorteilhafterweise können bzw. kann der Koppler und/oder die Koppelantenne und/oder das Sensorelement und/oder der Auskoppelwiderstand und/oder das Auskoppelelement als Struktur auf der Leiterplatte vorgesehen sein.

Vorzugsweise kann der Funkknoten energieautark betrieben werden. Zweckmäßigerweise umfasst der Funkknoten hierfür eine Batterie, z. B. eine Longlife-Batterie.

Vorteilhafterweise kann der Funkknoten Bestandteil eines Durchflusszählers oder eines Stromzählers oder eines Energiezählers oder eines Verbrauchszählers sein. Ferner kann der Funkknoten Bestandteil eines Funkmoduls für einen Durchflusszähler oder einen Stromzähler oder einen Energiezähler oder einen Verbrauchszähler sein.

Idealerweise handelt es sich bei dem Funkknoten um einen mobilen bzw. beweglichen Funkknoten.

Zweckmäßigerweise ist die Antenne am oder im Funkknoten bzw. Gehäuse des Funkknotens integriert. Insbesondere kann die Antenne fest mit dem Funkknoten bzw. dessen Gehäuse verbunden sein. Hierdurch wird eine kompakte Bauform des Funkknotens gewährleistet.

Vorzugsweise sendet der Funkknoten, insbesondere schmalbandige, Funksignale in einem Frequenzbereich von 100 MHz bis 500 MHz aus. Besonders bevorzugt sendet der Funkknoten im Frequenzbereich von 433,0500 - 434,7900 MHz und/oder von 169,4000 - 169,8125 MHz aus.

Zweckmäßigerweise findet die Funkübertragung mit einer Datenrate kleiner als 250 kbit/s statt.

### Beschreibung der Erfindung anhand von Ausführungsbeispielen

Nachstehend werden zweckmäßige Ausführungsbeispiele der Erfindung anhand von Zeichnungsfiguren näher erläutert. Wiederkehrende Merkmale sind der Übersichtlichkeit halber lediglich einmal mit einem Bezugszeichen gekennzeichnet. Es zeigen:
- Fig. 1: ein Blockschaltbild eines beispielhaften grundsätzlichen Ablaufs des erfindungsgemäßen Verfahrens;
- Fig. 2: ein beispielhaftes Blockschaltbild des Aufbaus eines Funkknotens zur Anwendung des erfindungsgemäßen Verfahrens gemäß einem ersten Ausführungsbeispiel;
- Fig. 3: ein beispielhaftes Blockschaltbild des Aufbaus des Funkknotens zur Anwendung des erfindungsgemäßen Verfahrens gemäß einem zweiten Ausführungsbeispiel;
- Fig. 3a: ein beispielhaftes Blockschaltbild des Aufbaus des Funkknotens gemäß Fig. 3 ohne eine Koppelantenne;
- Fig. 4: ein beispielhaftes Blockschaltbild des Aufbaus des Funkknotens gemäß Fig. 3 mit einer gemeinsamen Koppelantenne;
- Fig. 5: ein beispielhaftes Blockschaltbild des Aufbaus des Funkknotens zur Anwendung des erfindungsgemäßen Verfahrens gemäß einem dritten Ausführungsbeispiel;
- Fig. 6: ein beispielhaftes Blockschaltbild des Aufbaus des Funkknotens gemäß Fig. 5 mit einer gemeinsamen Koppelantenne;
- Fig. 7: ein beispielhaftes Blockschaltbild des Aufbaus des Funkknotens gemäß Fig. 5 mit einem Mikrocontroller;
- Fig. 8: ein beispielhaftes Blockschaltbild des Aufbaus des Funkknotens gemäß Fig. 5 mit einem Regler und einem Mikrocontroller;
- Fig. 9: ein beispielhaftes Blockschaltbild des Aufbaus des Funkknotens gemäß Fig. 8 mit einem Analogschalter mit Haltefunktion;
- Fig. 10: ein beispielhaftes Blockschaltbild des Aufbaus des Funkknotens zur Anwendung des erfindungsgemäßen Verfahrens gemäß einem vierten Ausführungsbeispiel;
- Fig. 11a: ein beispielhaftes Blockschaltbild eines ersten Kopplungsbeispiels einer Varaktordiode mit einer Antenne;
- Fig. 11b: ein beispielhaftes Blockschaltbild eines zweiten Kopplungsbeispiels der Varaktordiode mit der Antenne;
- Fig. 12a: ein beispielhaftes Blockschaltbild eines an die Antenne gekoppelten Kapazitätsnetzwerkes sowie
- Fig. 12b: ein beispielhaftes Blockschaltbild eines an die Antenne gekoppelten Induktivitätsnetzwerkes.

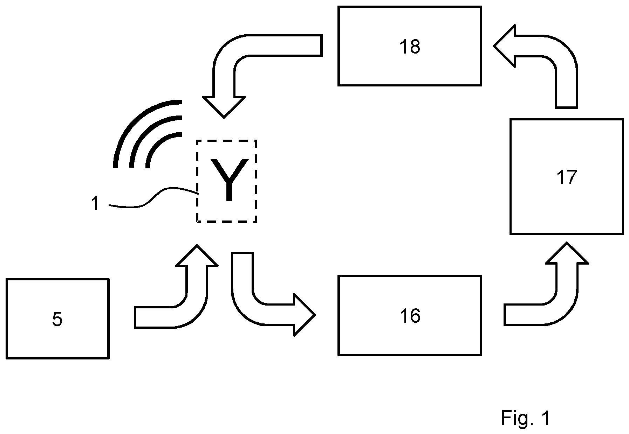

Fig. 1 zeigt ein Blockschaltbild eines beispielhaften grundsätzlichen Ablaufs des erfindungsgemäßen Verfahrens. Ein Funkchip 5 überträgt hierbei ein Funksignal, z. B. ein HF-Funksignal, an eine Antenne 1. Die Antenne 1 kann hierbei am oder im Funkknoten bzw. Gehäuse desselben integriert sein. Erfindungsgemäß wird das Funksignal oder zumindest ein Teil desselben aus der Antenne 1 und/oder aus einem (in der Fig. nicht dargestellten) Sendepfad 14 zwischen dem Funkchip 5 und der Antenne 1 ausgekoppelt. In Abhängigkeit der ermittelten Impedanz und/oder Resonanzfrequenz wird mittels einer auf die Antenne 1 einwirkenden Schaltung die Impedanz und/oder die Resonanzfrequenz der Antenne 1 angepasst. Dies entspricht dem prinzipiellen Ablaufschema der Fig. 1. Das ausgekoppelte Funksignal oder ein Teil desselben wird über ein Interface 16 einer Steuer- bzw. Regel- bzw. Recheneinheit 17 zugeführt, mittels der über ein Interface 18 eine Impedanzänderung und/oder Resonanzfrequenzänderung der Antenne 1 bewirkt wird. Dieses grundsätzliche Verfahrensschema wird anhand der weiteren nachfolgenden Figuren durch vorteilhafte Ausgestaltungen umgesetzt.

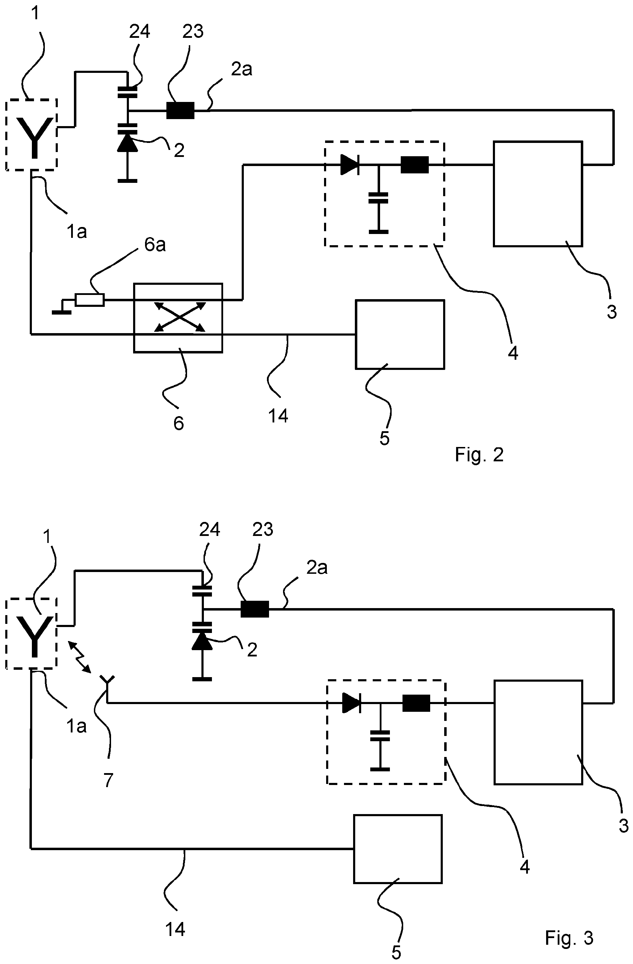

Fig. 2 zeigt das Blockschaltbild des Funkknotens zur Anwendung des erfindungsgemäßen Verfahrens gemäß einem ersten Ausführungsbeispiel. Der Funkknoten umfasst den Funkchip 5 sowie die Antenne 1, welche über den Sendepfad 14 miteinander verbunden sind. Der Funkchip 5 übermittelt über den Sendepfad 14 ein Funksignal, z. B. Hochfrequenz (HF)-Signal, an die Antenne 1, welche das Funksignal aussendet.

Am Sendepfad 14 ist ein Koppler 6 angeordnet, welcher mit einer Gleichrichterschaltung 4, z. B. einer Gleichrichterschaltung aus Dioden, verbunden ist. Der Koppler 6 umfasst einen Abschlusswiderstand 6a. Ferner umfasst der Funkknoten eine auf die Antenne 1 einwirkende Schaltung, welche einen Mikrocontroller 3 und eine Varaktordiode 2 umfasst. Der Mikrocontroller 3 ist eingangsseitig mit der Gleichrichterschaltung 4 und ausgangsseitig mit der Varaktordiode 2 über deren Steuerungseingang 2a verbunden ist. Die Varaktordiode 2 ist galvanisch oder kapazitiv mit der Antenne 1 oder einem Antennenfußpunkt gekoppelt.

Die Varaktordiode 2 ist ein Halbleiterbauteil, bei welcher sich die Kapazität durch Änderung einer angelegten Steuerspannung ändert. Hierfür legt der Mikrocontroller 3 an dem Steuereingang 2a der Varaktordiode 2 eine Steuerspannung, insbesondere ein DC-Spannung, an. Durch eine Erhöhung der Steuerspannung am Steuereingang 2a sinkt die Kapazität der Varaktordiode 2. Durch eine Reduzierung der Steuerspannung am Steuereingang 2a steigt hingegen die Kapazität der Varaktordiode 2. Die Steuerspannung und/oder die Kapazität der Varaktordiode 2 lassen sich zweckmäßigerweise in diskreten Stufen verändern.

Aufgrund der Kopplung zwischen der Antenne 1 und der Varaktordiode 2 stellt die Kapazität der Varaktordiode 2 eine kapazitive Belastung der Antenne 1 dar. Dadurch verändert sich die Impedanz und/oder die Resonanzfrequenz der Antenne 1 in Abhängigkeit der Kapazität der Varaktordiode 2. Infolgedessen kann durch eine gezielte Änderung der Steuerspannung der Varaktordiode 2 die Impedanz und/oder die Resonanzfrequenz der Antenne 1 beeinflusst werden. Da die Steuerspannung und/oder die Kapazität der Varaktordiode 2 in diskreten Stufen einstellbar sind, kann die Impedanz und/oder die Resonanzfrequenz der Antenne 1 ebenfalls in diskreten Stufen eingestellt werden.

Ferner sind ein Koppelkondensator als Kapazität 24 und eine Drossel als Induktivität 23 vorgesehen. Der Koppelkondensator und die Drossel entkoppeln den Steuerkreis der Varaktordiode 2 von der Antenne 1 bzw. von dem Funksignal der Antenne 1.

Gemäß dem ersten Ausführungsbeispiel nach Fig. 2 sendet der Funkchip 5 ein auszusendendes Funksignal als vorlaufende Welle über den Sendepfad 14 an die Antenne 1. Das auszusendende Funksignal wird hierbei über einen Antennenfußpunk 1a, also einen Funksignaleingang, in die Antenne 1 eingespeist. Bei einer optimalen Antennenanpassung wird im Wesentlichen das vollständige Funksignal in die Antenne 1 eingespeist und von dieser ausgesendet. Im Falle einer Antennenverstimmung wird ein Teil des Funksignals vom Antennenfußpunkt 1a reflektiert und wandert als rücklaufende Welle zurück in Richtung des Funkchips 5. Das reflektierte Funksignal ist von der Antennenverstimmung abhängig. Das bedeutet, je größer die Antennenverstimmung ist, desto größer ist der reflektierte Teil des Funksignals.

Die rücklaufende Welle des Funksignals wird mittels des Kopplers 6 von dem Sendepfad 14 ausgekoppelt und dadurch von der vorlaufenden Welle getrennt. Die rücklaufende Welle wird vom Koppler 6 der Gleichrichterschaltung 4 zugeleitet. Die Gleichrichterschaltung 4 gibt eine von der rücklaufenden Welle bzw. der HF-Leistung der rücklaufenden Welle abhängige DC-Spannung aus. Diese DC-Spannung wird zur weiteren Auswertung dem Mikrocontroller 3 zugeleitet.

Anstelle der Gleichrichterschaltung 4 kann die rücklaufende Welle durch Abtastung oder mittels eines (in den Figuren nicht dargestellten) Analog-Digital-Wandlers digitalisiert werden. Hierbei wird die Amplitude des HF-Signals der rücklaufenden Welle ermittelt und diese dem Mikrocontroller 3 zugeleitet.

Im Mikrocontroller 3 sind vorzugsweise Referenzwerte abgespeichert, welche verschiedenen Impedanzen und/oder Resonanzfrequenzen der Antenne 1 entsprechen. Diese Referenzwerte können als DC-Spannung bzw. als Amplitude des HF-Signals hinterlegt sein. Alternativ kann die von der Gleichrichterschaltung 4 zugeleitete DC-Spannung bzw. die Amplitude des HF-Signals mittels eines Kennfeldes in eine entsprechende Impedanz und/oder Resonanzfrequenz der Antenne 1 umgewandelt werden und mit den hinterlegten Referenzwerten verglichen werden. Hierdurch kann festgestellt werden, ob eine Antennenverstimmung vorliegt. Die Antennenanpassung kann mittels eines SWEEP-Verfahrens vorgenommen werden. Bei dem SWEEP-Verfahren sweept bzw. taktet der Mikrocontroller 3 die einzelnen Antennenanpassungen aufgrund unterschiedlicher Steuerspannungswerte der Varaktordiode 2 durch, sodass der Abstimmbereich, vorzugsweise der vollständige Abstimmbereich, der Antenne 1 abgedeckt ist.

Für den Fall, dass eine Antennenverstimmung vorliegt oder keine Referenzwerte abgespeichert sind, z. B. bei der Inbetriebnahme des Funkknotens, wird eine Suchphase gestartet. Alternativ oder zusätzlich kann die Suchphase periodisch, in gleichen oder ungleichen Zeitabständen, gestartet werden. Bei der Suchphase wird die Antennenanpassung z. B. mittels des SWEEP-Verfahrens vorgenommen. Das bedeutet, dass während der Suchphase der Mikrocontroller 4 die Steuerspannung der Varaktordiode 2, z. B. kontinuierlich, von dem unteren bis zum oberen Ende des Abstimmbereiches der Antenne 1 steigert. Hierdurch wird die Belastung der Antenne 1 und somit deren Impedanz und/oder Resonanzfrequenz, insbesondere kontinuierlich, verändert. Währenddessen sendet der Funkchip 5 ein auszusendendes Funksignal an die Antenne 1. Dieses Funksignal wird in Abhängigkeit der Antennenverstimmung unterschiedlich stark von der Antenne 1 reflektiert. Die rücklaufende Welle wird, wie oben beschrieben, von dem Koppler 6 aus dem Sendepfad 14 ausgekoppelt und dem Mikrochip 3 zugeleitet. Der Mikrochip 3 erhält somit in Abhängigkeit von der Steuerspannung der Varaktordiode 2 unterschiedliche DC-Spannungen.

Da die dem Mikrocontroller 4 zugeleitete DC-Spannung der rücklaufenden Welle bzw. deren HF-Leistung entspricht, ist die Antenne 1 dann richtig abgestimmt, wenn die DC-Spannung minimal ist. Der Mikrocontroller 4 ermittelt somit das Minimum der ihm zugeleiteten DC-Spannung. Die Steuerspannung für die Varaktordiode 2, bei welcher die rücklaufende Welle minimal ist, wird im Mikrocontroller 4 als Referenzwert gespeichert und für nachfolgende Funkübertragungen, während einer Betriebsphase, verwendet. Sobald eine erneute Antennenverstimmung festgestellt wird, z. B. aufgrund von Änderungen in der Einbausituation, und/oder periodisch, in gleichen oder ungleichen Zeitabständen, wird erneut die Suchphase eingeleitet.

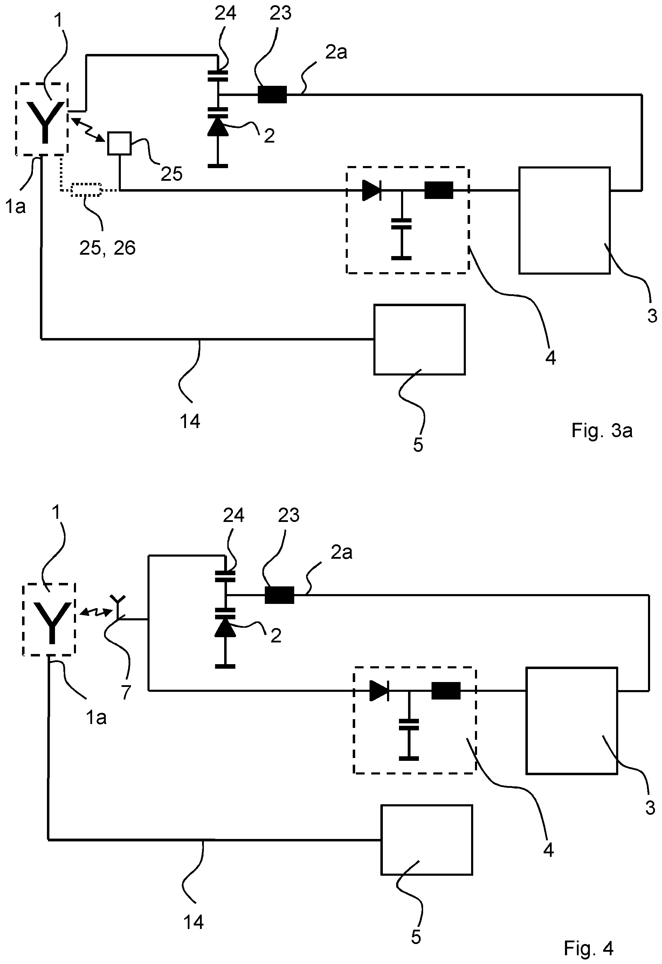

Fig. 3 zeigt ein zweites Ausführungsbeispiel des Funkknotens zur Ausführung des erfindungsgemäßen Verfahrens. Die Funktionsmerkmale des Funkknotens des zweiten Ausführungsbeispiels entsprechen im Wesentlichen den Funktionsmerkmalen des Funkknotens des ersten Ausführungsbeispiels. Lediglich anstelle des Kopplers 6 ist im zweiten Ausführungsbeispiel eine Koppelantenne 7 vorgesehen.

Bei dem zweiten Ausführungsbeispiel wird ebenfalls ein auszusendendes Funksignal vom Funkchip 5 über den Sendepfad 14 der Antenne 1 zugeführt. Die Antenne 1 sendet das Funksignal aus. Hierbei wird zumindest ein Teil der auf der Antenne 1 befindlichen Energie bzw. Leistung des Funksignals mittels der Koppelantenne 7 abgegriffen. Die abgegriffene Energie bzw. Leistung ist abhängig von der auf der Antenne 1 befindlichen Energie bzw. Leistung des Funksignals. Je besser die Anpassung der Antenne 1 an den Funkchip 5 in Bezug auf Impedanz und/oder Resonanzfrequenz ist, desto größer ist die auf der Antenne 1 befindliche Energie bzw. Leistung des Funksignals und desto größer ist damit die Energie bzw. Leistung des von der Koppelantenne 7 abgegriffenen Signals. Diese wird der Gleichrichterschaltung 4 zugeführt bzw. digitalisiert und dem Mikrocontroller 3 gemäß dem ersten Ausführungsbeispiel zugeführt. Wie oben beschrieben, kann nun ermittelt werden, ob eine Antennenverstimmung vorliegt.

Analog zum ersten Ausführungsbeispiel kann bei dem zweiten Ausführungsbeispiel eine Antennenanpassung in der Suchphase mittels des SWEEP-Verfahrens durchgeführt werden. Die Energie bzw. Leistung des Funksignals auf der Antenne 1 ist abhängig von der Impedanz und/oder Resonanzfrequenz der Antenne 1. Demnach ist die Antenne 1 dann richtig abgestimmt, wenn die Energie bzw. Leistung des Funksignals auf der Antenne 1 maximal ist. Der Mikrocontroller 3 ermittelt demnach während des SWEEP-Verfahrens das Maximum der mittels der Koppelantenne 7 abgegriffenen Energie bzw. Leistung. Die entsprechende Steuerspannung wird nun für nachfolgende Funkübertragungen in der Betriebsphase verwendet. Bei einer erneuten Antennenverstimmung und/oder periodisch, in gleichen oder ungleichen Zeitabständen, wird die Suchphase erneut gestartet.

Alternativ kann zumindest ein Teil der von der Antenne 1 abgestrahlten Leistung gemäß Fig. 3a über ein Sensorelement 25 anstelle der Koppelantenne 7 abgegriffen werden. Dieses Sensorelement 25 ist hierbei kapazitiv oder induktiv oder galvanisch (gestrichelt in der Fig. 3a dargestellt) an die Antenne 1 gekoppelt. Ferner kann zumindest ein Teil der auf der Antenne 1 befindlichen Energieüber ein Auskoppelelement 26, z. B. einen Auskoppelwiderstandabgegriffen werden, vgl. gestrichelte Darstellung in der Fig. 3a. Die weitere Auswertung der abgegriffenen Leistung oder Energie findet analog zu dem zweiten Ausführungsbeispiel statt.

Fig. 4 zeigt eine Abwandlung des Funkknotens gemäß Fig. 3. Die Varaktordiode 2 ist hierbei mittels der Koppelantenne 7 kapazitiv an die Antenne 1 gekoppelt. Somit dient die Koppelantenne 7 einerseits zur Auskopplung der auf der Antenne 1 befindlichen Energie bzw. Leistung des Funksignals und andererseits dazu, auf die Antenne 1 dahingehend einzuwirken, dass die Varaktordiode 2 die Impedanz und/oder die Resonanzfrequenz der Antenne 1 anpassen kann.

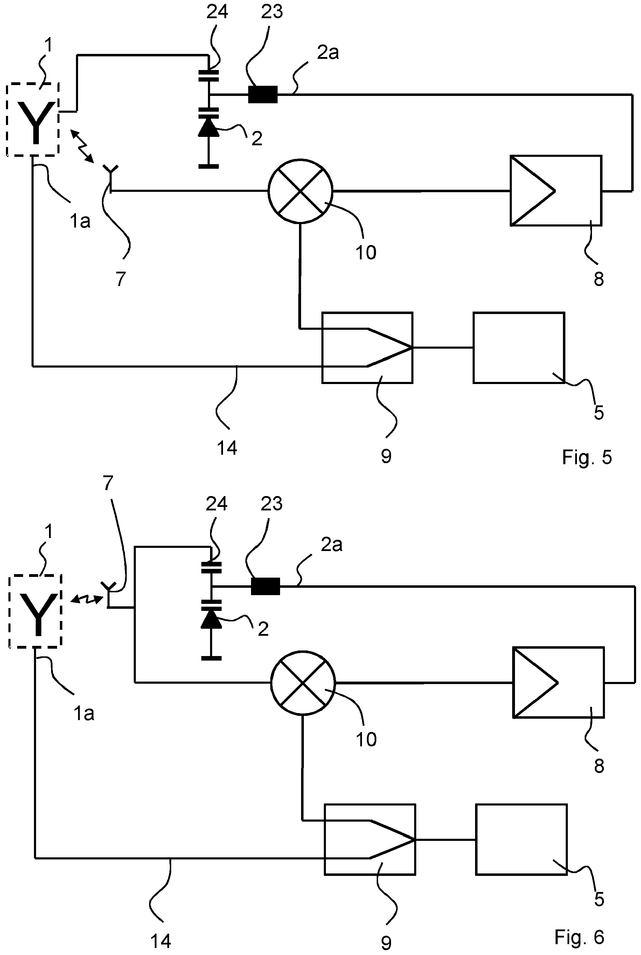

Fig. 5 zeigt ein Blockschaltbild des Aufbaus des Funkknotens zur Anwendung des erfindungsgemäßen Verfahrens gemäß einem dritten Ausführungsbeispiel. Wie in dem vorhergehenden zweiten Ausführungsbeispiel umfasst der Funkknoten eine Varaktordiode 2, eine Antenne 1, einen Funkchip 5, einen Sendepfad 14 sowie eine Koppelantenne 7. Zudem umfasst der Funkknoten einen Leistungsteiler 9, welcher im Sendepfad 14 angeordnet ist. Die Koppelantenne 7 und der Leistungsteiler 9 sind mit einem Phasenkomparator 10 verbunden. Als Phasenkomparator 10 kann z. B. ein aus Dioden aufgebauter Mischer dienen. Ferner umfasst die auf die Antenne 1 einwirkende Schaltung einen Regler 8, welcher eingangsseitig mit dem Phasenkomparator 10 und ausgangsseitig mit der Varaktordiode 2 verbunden ist.

Bei dem dritten Ausführungsbeispiel wird die Antennenanpassung zweckmäßigerweise mittels eines geschlossenen Regelkreises vorgenommen. Hierbei wird die auf der Antenne 1 befindliche Energie des Funksignals wie bei dem zweiten Ausführungsbeispiel ausgekoppelt und dem Phasenkomparator 10 zugeführt. Zudem wird mittels des Leistungsteilers 9 ein Teil des Funksignals im Sendepfad 14 ausgekoppelt und ebenfalls dem Phasenkomparator 10 zugeführt. Der Phasenkomparator 10 vergleicht die Phase des von der Antenne 1 abgegriffenen Funksignals mit der Phase des im Sendepfad 14 abgegriffenen Funksignals und gibt eine von der Phasendifferenz abhängige Gleichspannung aus.

Diese Gleichspannung wird dem Regler 8 zugeleitet. Der Regler 8 vergleicht die anliegende DC-Spannung mit einem Referenzwert bzw. einer Referenzspannung. Der Referenzwert entspricht dem Wert, bei welchem eine optimale bzw. gewünschte Antennenanpassung vorliegt. Da die anliegende DC-Spannung über oder unter dem Referenzwert liegen kann, kann hierdurch die Richtung der Antennenverstimmung festgestellt werden. Demnach erhöht oder reduziert der Regler 8 die Steuerspannung der Varaktordiode 2 derart, dass die am Regler 8 anliegende DC-Spannung im Wesentlichen dem Referenzwert entspricht.

Durch die Regelung der Antennenanpassung mittels des geschlossenen Regelkreises kann die Antennenverstimmung bzw. Antennenabstimmung unmittelbar während des Aussendens des Funksignals angepasst werden. Hierdurch wird ein SWEEP-Verfahren vermieden und eine Antennenverstimmung kann direkt während einer Funkübertragung ausgeglichen werden.

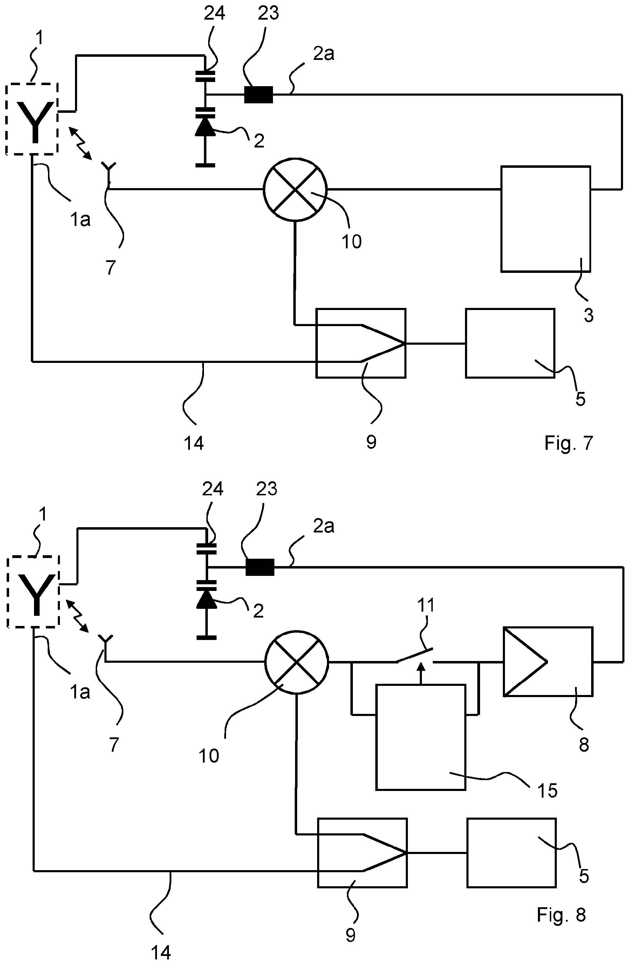

Die Varaktordiode 2 des dritten Ausführungsbeispiels kann über die Koppelantenne 7, analog zu Fig. 4, kapazitiv an die Antenne 1 gekoppelt sein, vgl. Fig. 6. Fig. 7 zeigt ein beispielhaftes Blockschaltbild des Funkknotens gemäß Fig. 5, bei welchem anstelle des Reglers 8 ein Mikrocontroller 3 vorgesehen ist. Der Mikrocontroller 3 erfüllt hierbei im Wesentlichen dieselben Funktionen wie der Regler 8. Ferner kann der Mikrocontroller 3 die Steuerspannungen abspeichern und im Empfangsfall eine Steuerspannung an die Varaktordiode 2 ausgeben, sodass auch in diesem Fall eine Antennenanpassung möglich ist. Hierbei gibt der Mikrocontroller 3 idealerweise die zuletzt gespeicherte Steuerspannung aus.

Das Blockschaltbild eines Funkchips gemäß Fig. 8 umfasst im Wesentlichen alle Funktionsmerkmale des Funkchips gemäß Fig. 5. Es sind allerdings zusätzlich ein Mikrocontroller 15 und ein Schalter 11 vorgesehen. Im Sendefall ist der Schalter 11 geschlossen. Die DC-Spannung fließt hierbei vom Phasenkomparator 10 zu dem Regler 8, welcher die Steuerspannung der Varaktordiode 2 anpasst.

Der Mikrocontroller 15 kann die vom Phasenkomparator 10 ausgegebene Spannung ermitteln und abspeichern. Im Empfangsfall öffnet der Mikrocontroller 15 den Schalter 11 und gibt die zuletzt gespeicherte Spannung aus und leitet diese dem Regler 8 zu. Der Regler 8 gibt daraufhin eine Steuerspannung an die Varaktordiode 2 aus, sodass die Impedanz und/oder Resonanzfrequenz der Antenne 1 angepasst wird. Hierdurch wird auch im Empfangsfall eine Antennenanpassung möglich.

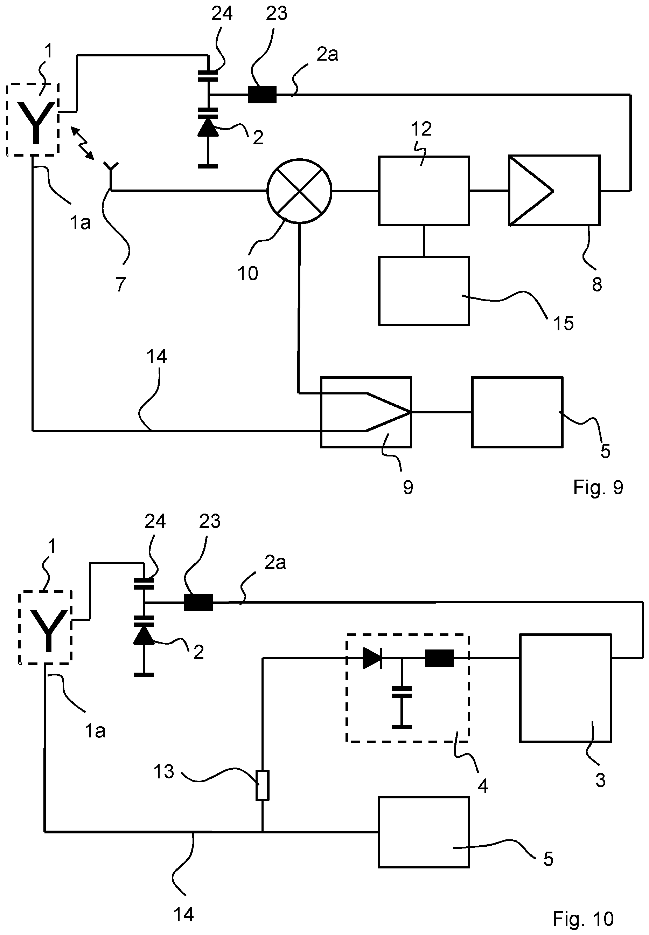

Fig. 9 zeigt eine alternative Ausgestaltung des Funkknotens gemäß Fig. 5. Hierbei ist zwischen dem Phasenkomparator 10 und dem Regler 8 ein Analogschalter 12 mit einer Haltefunktion vorgesehen, welcher mit dem Mikrocontroller 15 verbunden ist. Im Sendefall überträgt der Analogschalter 12 die DC-Spannung vom Phasenkomparator 10 an den Regler 8 und speichert diese ab. Der Regler 8 gibt daraufhin eine von der DC-Spannung abhängige Steuerspannung für die Varaktordiode 2 aus. Im Empfangsfall steuert der Mikrocontroller 15 den Analogschalter 12 an, sodass dieser die zuletzt gespeicherte DC-Spannung dem Regler 8 zuleitet. Infolgedessen kann das Verfahren gemäß dem dritten Ausführungsbeispiel auch im Empfangsfall verwendet werden.

Fig. 10 zeigt ein Blockschaltbild des Aufbaus des Funkknotens zur Anwendung des erfindungsgemäßen Verfahrens gemäß einem vierten Ausführungsbeispiel. Der Aufbau des Funkknotens entspricht hierbei im Wesentlichen dem Aufbau des Funkknotens gemäß Fig. 2. Jedoch ist anstelle des Kopplers 6 ein Auskoppelwiderstand 13 vorgesehen. Über diesen Auskoppelwiderstand 13 wird zumindest ein Teil des Funksignals bzw. dessen HF-Spannung im Sendepfad 14 ausgekoppelt. Der ausgekoppelte Teil des Funksignals bzw. dessen HF-Spannung stellt eine Überlagerung der vorlaufenden und der rücklaufenden Welle dar.

Das ausgekoppelte Funksignal wird mittels der Gleichrichterschaltung 4 in eine DC-Spannung umgewandelt bzw. digitalisiert und dem Mikrocontroller 3 zugeleitet. Die dem Mikrocontroller 3 zugeleitete Spannung wird mit einem Referenzwert bzw. einer Referenzspannung verglichen. Der Referenzwert wurde vorab bestimmt und entspricht einer optimalen bzw. gewünschten Impedanz und/oder Resonanzfrequenz der Antenne 1. Falls eine Antennenverstimmung festgestellt wird und/oder periodisch, in gleichen oder ungleichen Zeitabständen, wird zur Antennenanpassung die Suchphase und das SWEEP-Verfahren gestartet. Hierbei wird überprüft, bei welchem Steuersignal der Varaktordiode 2 der Referenzwert erreicht wird.

Bei dem vierten Ausführungsbeispiel kann es aufgrund der Überlagerung der vorlaufenden und rücklaufenden Welle zu Mehrdeutigkeiten kommen. D. h. mehrere Impedanzen und/oder Resonanzfrequenzen der Antenne 1 führen zu der gleichen DC-Spannung, welche dem Mikrocontroller 3 zugeleitet wird. Diese Mehrdeutigkeiten können vermieden werden, indem mittels eines Pre-Matching diejenigen Impedanzen und/oder Resonanzfrequenzen der Antenne 1, bei denen es zu Mehrdeutigkeiten kommen kann, gezielt nicht angesteuert werden. Diese Impedanzen und/oder Resonanzfrequenzen können hierfür vorab bestimmt werden.

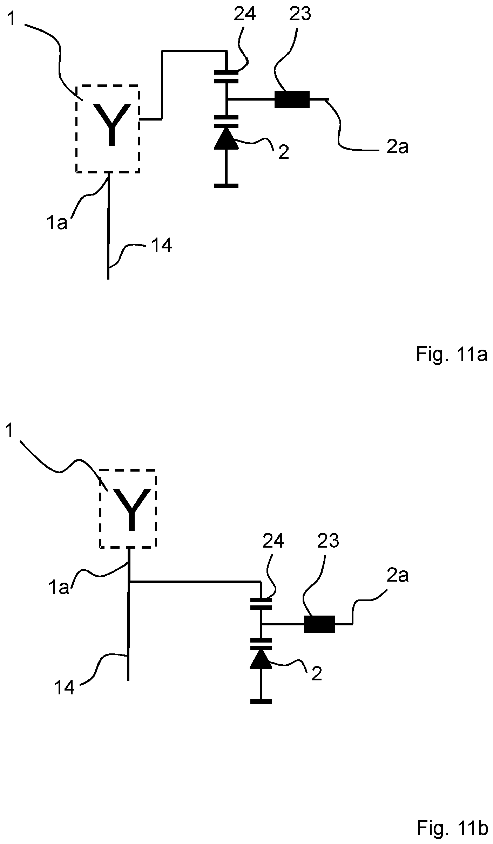

Figuren 11a und 11b zeigen unterschiedliche Kopplungsbeispiele der Varaktordiode 2 an die Antenne 1. Gemäß dem ersten Kopplungsbeispiel, vgl. Fig. 11a, verläuft das Funksignal über den Sendepfad 14 und den Antennenfußpunkt 1a zu der Antenne 1. Die Varaktordiode 2 verfügt hierbei über eine eigene Ankopplung zu der Antenne 1. Somit ist das Funksignal und die durch die Varaktordiode 2 bedingte kapazitive Belastung getrennt voneinander.

Gemäß dem zweiten Kopplungsbeispiel, vgl. Fig. 11b, sind die Varaktordiode 2 und der Sendepfad 14 über den Antennenfußpunkt 1a mit der Antenne 1 gekoppelt. Somit haben beiden denselben Kopplungspunkt mit der Antenne 1.

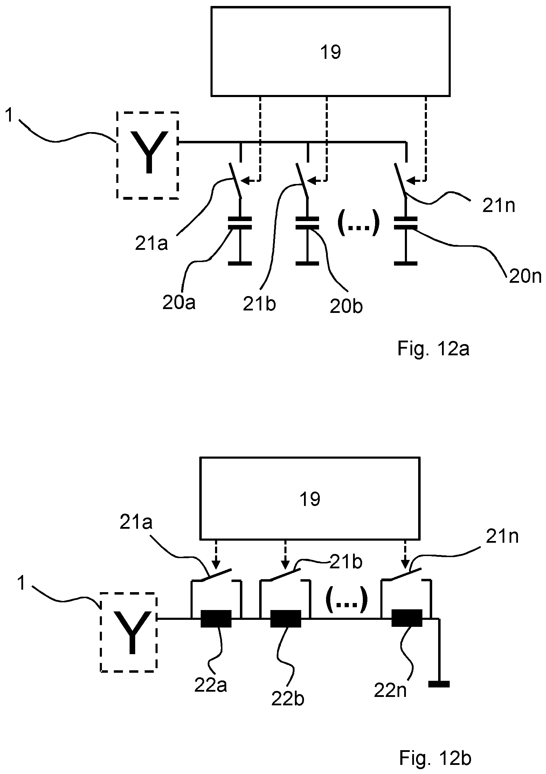

Anstelle oder zusätzlich zu der Varaktordiode 2 zur Einstellung der Impedanz und/oder der Resonanzfrequenz der Antenne 1 kann gemäß Figuren 12a und 12b ein schaltbares Netzwerk mit mehreren Kapazitäten 20a-n oder mehreren Induktivitäten 22a-n vorgesehen sein. Zudem kann das Netzwerk eine (in den Figuren nicht dargestellte) Kombination aus mindestens einer Kapazität 20a-n und mindestens einer Induktivität 22a-n aufweisen. Das Netzwerk kann hierbei galvanisch oder kapazitiv oder induktiv an die Antenne 1 gekoppelt sein.

Das Netzwerk gemäß Fig. 12a umfasst mehrere Kapazitäten 20a-n sowie den jeweiligen Kapazitäten 20a-n zugeordnete Schalter 21a-n. Mittels eines Mikrocontrollers 19 können die Schalter 21a-n einzeln angesteuert werden und hierbei geöffnet oder geschlossen werden, sodass die entsprechenden Kapazitäten 20a-n auf die Antenne 1 einwirken können. Dadurch, dass die Schalter 21a-n einzeln ansteuerbar sind, kann ein einzelner Schalter 21a-n oder auch mehrere Schalter 21a-n geschlossen werden, sodass verschiedene Kapazitäten 20a-n gleichzeitig auf die Antenne 1 einwirken können. Zweckmäßigerweise weisen die Kapazitäten 20a-n unterschiedlichen Werte auf.

Ferner kann zur Einstellung der Impedanz und/oder der Resonanzfrequenz der Antenne 1 gemäß Fig. 12b ein schaltbares Netzwerk mit mehreren Induktivitäten 22a-n vorgesehen sein. Das Induktivitätsnetzwerk umfasst mehrere Schalter 21an, welche den entsprechenden Induktivitäten 22a-n zugeordnet sind. Die Schalter 21a-n können analog zu Fig. 12a mittels des Mikrocontrollers 19 einzeln angesteuert werden, sodass die entsprechenden Induktivitäten 22a-n auf die Antenne einwirken kann. Die Induktivitäten 22a-n können ebenfalls unterschiedliche Werte aufweisen.

Zweckmäßigerweise können die Funkknoten gemäß den obenstehenden Ausführungsbeispielen energieautark betrieben werden. Hierfür kann beispielsweise eine (in den Figuren nicht dargestellte) Batterie, insbesondere eine Longlife-Batterie, verwendet werden.

Zudem kann der Funkknoten Bestandteil eines Durchflusszählers oder eines Stromzählers oder eines Energiezählers oder eines Verbrauchszählers sein.

Die Erfindung ermöglicht es somit, die Antennenverstimmung direkt am Funkknoten zu bestimmen. Ebenfalls wird es durch die Erfindung ermöglicht, die Antennenverstimmung mittels einer vom Funknoten selbsttätig durchgeführten Antennenanpassung zu beheben. Hierfür wird in einfacher Weise mittels einer auf die Antenne 1 einwirkenden Schaltung, z. B. einer Varaktordiode 2, die Impedanz und/oder die Resonanzfrequenz der Antenne 1 angepasst.

Es wird ausdrücklich darauf hingewiesen, dass auch die Kombination von Einzelmerkmalen sowie Untermerkmalen als erfindungswesentlich und vom Offenbarungsgehalt der Anmeldung umfasst anzusehen sind.

### BEZUGSZEICHENLISTE

- 1: Antenne
- 1a: Antennenfußpunkt
- 2: Varaktordiode
- 2a: Steuerungseingang
- 3: Mikrocontroller
- 4: Gleichrichterschaltung
- 5: Funkchip
- 6: Koppler
- 6a: Abschlusswiderstand
- 7: Koppelantenne
- 8: Regler
- 9: Leistungsteiler
- 10: Phasenkomparator
- 11: Schalter
- 12: Analogschalter
- 13: Auskoppelwiderstand
- 14: Sendepfad
- 15: Mikrocontroller
- 16: Interface
- 17: Recheneinheit
- 18: Interface
- 19: Mikrocontroller
- 20a-n: Kapazität
- 21a-n: Schalter
- 22a-n: Induktivität
- 23: Induktivität
- 24: Kapazität
- 25: Sensorelement
- 26: Auskoppelelement

## Patentansprüche

1. Verfahren zum Verbessern der Antennenanpassung bei einem Funcknoten, vorzugsweise eines Sensor- und/oder Aktor-Funkknotens, **dadurch gekennzeichnet, dass**
ein Funksignal oder zumindest ein Teil desselben aus der Antenne (1) und/oder aus dem Sendepfad (14) des Funkknotens ausgekoppelt werden bzw. wird,
daraus im Funkknoten die Impedanz und/oder die Resonanzfrequenz der Antenne (1) ermittelt wird, und
in Abhängigkeit der ermittelten Impedanz und/oder Resonanzfrequenz mittels einer auf die Antenne (1) einwirkenden Schaltung die Impedanz und/oder die Resonanzfrequenz der Antenne (1) angepasst wird.

2. Verfahren nach Anspruch 1, **dadurch gekennzeichnet, dass** die auf die Antenne (1) einwirkende Schaltung ein, vorzugsweise schaltbares, Netzwerk umfasst, welches
- mindestens eine, vorzugsweise mehrere, Kapazitäten (20a-n, 24) und/oder
- mindestens eine, vorzugsweise mehrere, Induktivitäten (22a-n, 23)
umfasst.

3. Verfahren nach Anspruch 1 oder 2, **dadurch gekennzeichnet, dass** die auf die Antenne (1) einwirkende Schaltung mindestens eine Varaktordiode (2) umfasst.

4. Verfahren nach einem der vorhergehenden Ansprüche, **dadurch gekennzeichnet, dass** die auf die Antenne (1) einwirkende Schaltung galvanisch oder kapazitiv oder induktiv an die Antenne (1) gekoppelt ist.

5. Verfahren nach Anspruch 4, **dadurch gekennzeichnet, dass** die galvanische oder kapazitive oder induktive Kopplung der Schaltung an der Antenne (1) und/oder am Antennenfußpunkt (1a) vorgesehen ist.

6. Verfahren nach einem der Ansprüche 2 bis 5, **dadurch gekennzeichnet, dass** es sich bei der mindestens einen Kapazität (24) um einen Koppelkondensator und/oder bei der mindestens einen Induktivität (23) um eine Drossel handelt.

7. Verfahren nach einem der vorhergehenden Ansprüche, **dadurch gekennzeichnet, dass** die auf die Antenne (1) einwirkende Schaltung einen Mikrocontroller (3) und/oder einen Regler (8) umfasst.

8. Verfahren nach einem der vorhergehenden Ansprüche, **dadurch gekennzeichnet, dass** zur Auskopplung des Funksignals oder zumindest eines Teils desselben aus der Antenne (1) und/oder dem Sendepfad (14)
- eine von der Antenne (1) reflektierte Welle ausgekoppelt wird, oder
- die von der Antenne (1) abgestrahlte Leistung oder zumindest ein Teil derselben abgegriffen wird, oder
- die auf der Antenne (1) befindliche Energie oder zumindest ein Teil derselben abgegriffen wird, oder
- ein Teil eines Funksignals abgegriffen wird, der sich aus der Überlagerung einer vorlaufenden und einer von der Antenne rücklaufenden oder reflektierten Welle ergibt.

9. Verfahren nach Anspruch 8, **dadurch gekennzeichnet, dass** die rücklaufende Welle oder die abgegriffene Leistung oder die abgegriffene Energie oder der abgegriffene Teil des Funksignals einer Gleichrichterschaltung (4) zugeführt wird.

10. Verfahren nach Anspruch 8 oder 9, **dadurch gekennzeichnet, dass** die rücklaufende Welle oder die abgegriffene Leistung oder die abgegriffene Energie oder der abgegriffene Teil des Funksignals durch Abtastung oder mittels eines Analog-Digital-Wandlers digitalisiert wird.

11. Verfahren nach einem der vorhergehenden Ansprüche, **dadurch gekennzeichnet, dass** ein Phasenvergleich zwischen dem aus der Antenne (1) ausgekoppelten Funksignal und dem aus dem Sendepfad (14) ausgekoppelten Funksignal vorgenommen wird.

12. Verfahren nach einem der vorhergehenden Ansprüche, **dadurch gekennzeichnet, dass** die Antennenanpassung mittels eines binären Suchverfahrens oder mittels eines Algorithmus oder mittels eines SWEEP-Verfahrens oder in einem geschlossenen Regelkreis vorgenommen wird.

13. Verfahren nach einem der vorhergehenden Ansprüche, **dadurch gekennzeichnet, dass** das Verfahren eine Suchphase umfasst, in der die Impedanz und/oder die Resonanzfrequenz der Antenne (1) ermittelt werden bzw. wird, und das Verfahren eine Betriebsphase umfasst, während der die in der Suchphase ermittelte Impedanz und/oder die Resonanzfrequenz der Antenne (1) mit der aktuellen Impedanz und/oder Resonanzfrequenz der Antenne (1) verglichen wird und
(a) bei einer Abweichung aus dem Vergleich und/oder
(b) periodisch, in gleichen oder ungleichen Zeitabständen, eine neue Suchphase gestartet wird.

14. Verfahren nach einem der vorhergehenden Ansprüche, **dadurch gekennzeichnet, dass** die Anpassung der Impedanz und/oder der Resonanzfrequenz der Antenne (1) in diskreten Stufen erfolgt.

15. Funkknoten umfassend
eine Antenne (1),
einen Funkchip (5),
eine auf die Antenne (1) einwirkende Schaltung zur Anpassung der Impedanz und/oder der Resonanzfrequenz der Antenne (1),
Mittel zur Auskopplung eines Funksignals oder zumindest eines Teils desselben aus der Antenne (1) und/oder dem Sendepfad (14) sowie
Mittel zur Ermittlung der Impedanz und/oder der Resonanzfrequenz der Antenne (1),
**dadurch gekennzeichnet, dass**
der Funkknoten derart hergerichtet ist, dass er nach dem Verfahren gemäß einem der vorhergehenden Ansprüche betreibbar ist.

16. Funkknoten nach Anspruch 15, **dadurch gekennzeichnet, dass** als Mittel zur Auskopplung
ein Koppler (6) und/oder
eine Koppelantenne (7) und/oder
ein Sensorelement (25) und/oder
ein Auskoppelelement (26) und/oder
ein Auskoppelwiderstand (13) vorgesehen sind bzw. ist.

17. Funkknoten nach Anspruch 16, **dadurch gekennzeichnet, dass** der Koppler (6) und/oder die Koppelantenne (7) und/oder das Sensorelement (25) und/oder das Auskoppelelement (26) und/oder der Auskoppelwiderstand (13) als Struktur auf der Leiterplatte vorgesehen sind bzw. ist.

18. Funkknoten nach einem der Ansprüche 15 bis 17, **dadurch gekennzeichnet, dass** der Funkknoten energieautark betrieben wird.

19. Funkknoten nach einem der Ansprüche 15 bis 18, **dadurch gekennzeichnet, dass** der Funkknoten Bestandteil eines Durchflusszählers oder eines Stromzählers oder eines Energiezählers oder eines Verbrauchszählers ist.
